Europäisches Patentamt

European Patent Office

Office européen des brevets

(19)

(11) Publication number: **0 054 189**
**B1**

(12) **EUROPEAN PATENT SPECIFICATION**

(45) Date of publication of patent specification: 20.04.88

(21) Application number: 81109700.5

(22) Date of filing: 14.11.81

(51) Int. Cl.⁴: **C 23 C 14/28,** H 01 L 21/203, H 01 L 21/363, B 01 J 19/08

(54) Improved photochemical vapor deposition method.

(30) Priority: 15.12.80 US 216041

(43) Date of publication of application:
23.06.82 Bulletin 82/25

(45) Publication of the grant of the patent:
20.04.88 Bulletin 88/16

(84) Designated Contracting States:
CH DE FR IT LI NL SE

(56) References cited:
US-A-3 678 889
US-A-3 904 505
US-A-3 951 698
US-A-3 992 233
US-A-4 022 928

J. Chem. Phys. 23 (1955), page 532
J. Electrochem.Soc. 119 (1972), pages 372-376

(73) Proprietor: Hughes Aircraft Company
7200 Hughes Terrace P.O. Box 45066
Los Angeles California 90045-0066 (US)

(72) Inventor: Peters, John W.
18219 Coastline Drive
Malibu California 90265 (US)
Inventor: Gebhart, Frank L.
5300 Vermont
Long Beach California 90814 (US)

(74) Representative: Kuhnen, Wacker & Partner
Schneggstrasse 3-5 Postfach 1729
D-8050 Freising (DE)

Courier Press, Leamington Spa, England.

## Description

This invention relates generally to a method for the photochemical vapor deposition of a layer of a radiation opaque silicon nitride material on the surface of a substrate by the radiation-induced chemical reaction of silane and ammonia as vapor phase reactants in a reaction chamber including a radiation-transparent quartz window on one wall of said chamber, comprising passing radiation of a wavelength of 0.2537 μm through said window and into said chamber containing said vapor phase reactants and mercury vapor to induce said photochemical vapor deposition of said material on the surface of the substrate positioned within the chamber being under vacuum.

In the fabrication of semiconductor integrated circuits and devices, the deposition of a layer of a selected material, such as a dielectric material, a semiconductive material, or a metal, is frequently required. In some cases, this deposition may be most satisfactorily accomplished by a photochemical reaction, i.e., a chemical reaction which is induced or initiated by radiation of a chosen wavelength. For example, one process for depositing a silicon nitride ($Si_3N_4$) dielectric layer uses a photosensitized reaction between silane ($SiH_4$) and hydrazine ($N_2H_4$), as disclosed in U.S. Patent No. 3,620,827 to M. G. Collet. In such a process, mercury (Hg) is excited by radiation of a particular wavelength (i.e. 0.2537 μm (2537 angstroms)) to form mercury in an exited state (Hg*). The Hg* then collides with the $SiH_4$ and the $N_2H_4$ to cause these molecules to form radicals which then react to form $Si_3N_4$.

In the above-discussed prior art process, the photochemical vapor deposition process is initiated by the transmission of ultraviolet radiation (e.g. 0.2537 μm) through a quartz window which forms the top surface of the vacuum deposition chamber. The photochemical vapor deposition reaction then occurs in the deposition chamber and the selected material, such as silicon nitride, is deposited on the surface of a selected substrate or other target. However, while the selected material is being deposited on the substrate or target, additional deposits of the same selected material are also formed on the internal face of the quartz window of the deposition chamber. If this deposited material is opaque to the ultraviolet radiation, as silicon nitride is, this deposited material diminishes the transparency of the quartz window, which, in turn, diminishes the amount of radiation which can enter the deposition chamber to initiate the desired photochemical reaction. Since the rate of the photochemical reaction is dependent upon the amount of initiating radiation entering the deposition chamber, this unwanted deposit of ultraviolet-opaque material on the quartz window significantly decreases the rate of the deposition reaction, and ultimately the reaction may cease altogether.

It is the alleviation of this latter problem of diminished window transparency to the selected radiation required for the initiation or inducement of a photochemical reaction caused by the formation on the window of deposits which are opaque to the selected radiation, to which the present invention is directed.

In a somewhat related area of prior art processes, certain vacuum systems, such as for the thermal evaporation and/or deposition of a metal, have used a window assembly in order to permit the operator to visually monitor the deposition as it occurs in the chamber. Such a system using a window assembly comprising a clear Teflon film that is manually advanced is described in the catalog of AIRCO Temescal of Berkeley, California, entitled "Viewvac Viewing Ports Model VV400."

The US—A—36 78 889 to Murakami describes a vacuum deposition process in which the source material is heated in a vacuum chamber to form a vapor stream and the vapor stream subsequently condenses on the substrate as well as other surfaces in the chamber. This US—A discloses a reflector assembly comprising a fluorinated resin film coated on a support body, which is placed in a vacuum deposition apparatus to reflect vapors of the material to be deposited in a desired direction. In addition, it is disclosed a viewing window in a vacuum evaporator in which the reflector assembly is positioned within the evaporator and parallel to the inside surface of the viewing window. The vacuum evaporation process of this US—A is a physical process in which a target material is vaporized and then condensed on a substrate and is vastly different from radiation-induced chemical reaction between gaseous reactants to form a solid reaction product which deposits on the substrate.

In addition, the same type of vacuum deposition process as the US—A—36 78 889 using a coating of a perfluoropolyether on the inner surface of the viewing window is described in U.S. Patent No. 4,022,928 to B. P. Piwcyzk. However, in the vacuum deposition processes just described, the window is provided for convenience only and is not an integral part of the deposition reaction and process, affecting the rate and efficiency thereof. Further, such a conversion of a material from the vapor phase to the condensed phase, as carried out according to the vacuum deposition processes just described, is merely a physical process of vaporizing and condensation and not a chemically interactive process as in case of the photochemical vapor deposition of silicon nitride where a radiation-induced chemical reaction between said selected vapor phase reactants takes place.

## Summary of the invention

The general purpose of this invention is to provide a new method for the photochemical vapor deposition of a layer of radiation-opaque silicon nitride material on the surface of a substrate which possesses most, if not all, of the advantages of the prior art photochemical vapor deposition processes while overcoming their above-mentioned significant disadvantages, and which minimizes the resistance to the transmission of reaction-inducing radiation caused by extraneous deposition products, and thus maximizes the efficiency and rate of the vapor deposition reaction.

According to the invention it was surprisingly found that the disadvantages of the prior art processes as mentioned above can be overcome by using a perfluorinated polyether film.

Therefore the inventive method is characterized by the fact that a film consisting of a perfluorinated polyether is provided on the internal face of said window prior to carrying out the vapor deposition process.

Preferably the perfluorinated polyether is Fomblin Y25. According to a preferred embodiment of the method of the invention said radiation is passed through both said window and said film to strike predetermined portions of a substrate for said photochemical vapor deposition, positioned within said chamber, to thereby form a desired patterned layer of said reaction products on said substrate.

It is possible to accomplish the inventive method by a photochemical vapor deposition apparatus comprising: (a) a reaction chamber having at least a portion thereof formed of quartz to provide a quartz window for the transmission of a selected wavelength of radiation through the quartz window into the reaction chamber; (b) a film consisting of a perfluorinated polyether deposited on the internal face of the quartz window to a predetermined thickness, with this perfluorinated polyether being transparent to the selected wavelength of radiation and having a relatively low adhesive affinity for the material to be deposited; (c) means for introducing a reactant gas mixture into the reaction chamber; (d) means for heating a substrate within the reaction chamber; (e) means for producing radiation of the selected wavelength and introducing this radiation into the reaction chamber through the quartz window; and (f) means for producing a vacuum in the reaction-chamber of sufficiently low pressure to enable the deposition reaction to occur. During the deposition process, the film formed on the internal face of the quartz window prevents undesirable or extraneous deposits of the selected radiation-opaque silicon nitride from forming on or immediately in front of the internal face of the quartz window. Thus, the window is maintained in a clean and transparent state which provides continuous transmission of the reaction-inducing radiation into the reaction chamber, and thus enhances the efficiency and rate of the deposition process.

The foregoing and other advantages and features of the present invention will be apparent from the following more particular description of the preferred embodiments of the invention, as illustrated in the accompanying drawings.

Fig. 1 is a schematic diagram of one photochemical vapor deposition system embodying the present invention.

Fig. 2 is a schematic diagram showing the details of the coated quartz window of Fig. 1.

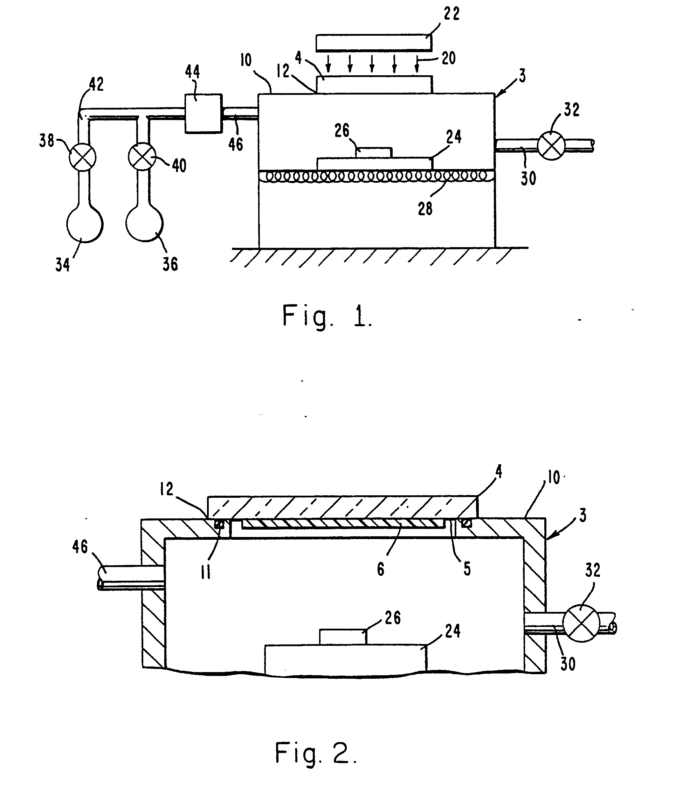

Fig. 1 shows, in simplified form, one photochemical vapor deposition system incorporating the coated quartz window in accordance with the present invention. The reaction chamber 3, which may be formed of stainless steel, aluminum, or other suitable structural material, has a window 4 which is made integral with the top surface of the reaction chamber 3 as described in further detail with reference to Fig. 2. The window 4 is formed of quartz, a material which is transmissive to the selected wavelength of radiation used to initiate the desired photochemical reaction. This radiation 20 is produced by the radiation-producing means 22 which may be, for example, an array of low pressure mercury vapor arc lamps. The internal face of the quartz window 4 is coated with a film consisting of a perfluorinated polyether as described in greater detail with respect to Fig. 2.

Within the reaction chamber 3, there is a substrate holder 24, which holds the substrate 26 onto which a layer of radiation-opaque silicon nitride material is to be deposited. The substrate 26 may be formed of any material which is capable of being subjected to a photochemical vapor deposition reaction. External to the reaction chamber 3 at the bottom surface thereof, there are heating elements 28 which are used to heat the substrate 26 to the required temperature so that appropriate film properties, such as density, may be obtained. A tube 30 leads from the reaction chamber 3 and passes through a valve 32 and then to a vacuum-producing means (not shown).

External to the reaction chamber 3, there are placed the chambers 34 and 36 which contain the individual reactant gases for the selected photochemical reaction, i.e. silane and ammonia. The chambers 34 and 36 are connected to the valves 38 and 40, respectively, which are used to control the amounts of reactants that are introduced into a tube 42. The reactant gases flow through the tube 42 into a chamber 44 which contains a pool of mercury having mercury vapor above it. The reactant gases thus become mixed in the chamber 44 with mercury vapor and this reactant gas mixture then passes through the tube 46 into the reaction chamber 3, where the photochemical reaction may be brought about.

The components of the apparatus shown in Fig. 1 may be constructed of stainless steel or aluminum unless otherwise specified.

The reaction chamber 3 with the flat quartz window 4 integral with the top surface thereof as shown in Fig. 1 is but one example of a reaction chamber used for carrying out the process of the present invention. Alternatively, the reaction chamber 3 which can be used according to the invention, may have any configuration in which at least a portion thereof is formed of quartz which is transmissive to the selected wavelength of radiation, to allow this radiation to enter the reaction chamber. For example, the reaction chamber 3 may comprise a hollow quartz tube with the entire internal surface or a selected portion thereof coated with the film consisting of the radiation-transparent, low surface energy perfluorinated polyether in accordance with the present invention, as described in relation to Fig. 2.

Attention is now directed to Fig. 2 for a more particular consideration of the quartz window 4. Prior to insertion of the quartz window 4 into the reaction chamber 3 as shown in Fig. 2, a layer or film consisting of a perfluorinated polyether is deposited on one surface of the quartz window 4, which will ultimately become the internal face 5 of the quartz window 4 when the quartz window 4 is incorporated into the chamber 3 as shown in Fig. 2. (The term "internal face" of the quartz window is used herein to mean that face of the quartz window which is internal to the reaction chamber.) This perfluorinated polyether is transparent to the selected wavelength of radiation of 0.2537 μm used to initiate the desired photochemical reaction, and further, has a relatively low adhesive affinity for the material to be deposited on the substrate. The term "adhesive affinity" is used herein to mean the probability for attraction and adhesion of the photochemical reaction products or fragments thereof on the perfluorinated polyether material. In addition, this perfluorinated polyether material is stable at the elevated temperature required for the deposition reaction and has sufficiently low vapor pressure so as not to significantly increase the evacuation time nor to produce contamination of the deposited layer. Such perfluorinated polyether material is a polymer with repeating ether linkages (—C—O—C-bonds) and carbon atoms saturated with fluorine. One particular perfluoropolyether which may be used is a compound sold under the trademark name Fomblin Y25 by the Montecatini-Edison Company. A layer of film of the perfluorinated polyether is deposited on the internal face 5 of the quartz window 4 to a thickness in the range of 0.2 to 2.0 μm, for example, by spraying, painting, or rolling a solution of the Fomblin Y25 polymer in trichlorotrifluoroethane or chloroform onto the internal face 5 and then allowing or causing the solvent to evaporate, as is known in the art of forming polymer films. Thus, the relatively thin film 6 of the perfluorinated polyether material is formed on the internal face 5 of the quartz window 4 as shown in Fig. 2. After the film 6 has been deposited on the internal face 5 of the quartz window 4, the quartz window 4 is positioned on the top surface of the reaction chamber 3 as illustrated in Fig. 2, with an O-ring 11 being placed at the junction 12 between the quartz window 4 and the top surface 10 of the reaction chamber 3. Then, a vacuum is formed in the reaction chamber 3 by withdrawing ambient air through the tube 30 and the valve 32 by the vacuum-producing means (not shown), and the quartz window 4 thus becomes integral with the reaction chamber 3. (The reference designators 24, 26, and 46 shown in Fig. 2 indicate the same structures as set forth in Fig. 1 and are shown for purposes of correlating Figs. 1 and 2.)

Using the apparatus shown in Figs. 1 and 2 for a photochemical vapor deposition reaction, the silicon nitride to be deposited does not adhere to film 6 of the perfluorinated polyether. It is believed that this perfluorinated polyether has a molecular structure and surface energy such that this material has a low adhesive affinity for silicon nitride. The film 6 of the perfluorinated polyether prevents reactant gases from coming in contact with the internal face 5 of the quartz window 4 and, further, prevents extraneous and unwanted deposits from forming either on the internal face 5 of the quartz window or immediately in front of this internal face 5 (i.e. on the film 6 itself). Consequently, the internal face 5 of the quartz window 4 is maintained in a clean and transparent state by the process of the present invention since the accumulation of deposition products on the internal face 5 which are opaque to reaction-inducing radiation and would attenuate, absorb, or provide a resistance to the radiation entering the deposition chamber through the quartz window 4 has been avoided. (This silicon nitride material which is opaque to the reaction-inducing radiation is referred to herein as "radiation-opaque" material.). Since the rate of deposition is directly proportional to the intensity of the radiation passing through the quartz window 4, the rate of the deposition reaction is significantly increased by the process of the present invention because the internal face 5 of the quartz window 4 is maintained in a clean and transparent state which provides continuous transmission of the reaction-inducing radiation into the reaction chamber.

Example 1

Using the apparatus described in Figs. 1 and 2, a layer of silicon nitride was photochemically deposited on a silicon substrate by the reaction of silane, ammonia, and mercury vapor. The source 22 of the ultraviolet radiation 20 shown in Fig. 1 was an array of low pressure mercury vapor arc lamps which produced radiation having a wavelength of 0.2537 μm (2537 Å). The film 6 was formed of Fomblin Y25 obtained from the Montecatini-Edison Company of Italy.

The layer 6 was formed to a thickness of approximately 0.4000 to 0.5000 μm (4,000 to 5,000 Å) by the spraying procedure previously described herein. A photochemical vapor deposition process was used which is similar to that described in U.S. Patent No. 4,181,751 to T. C. Hall and J. W. Peters, assigned to the present assignee, with the optional omission of the silane pretreatment of ammonia. The reaction chamber 3, with the coated quartz window 4 in place as shown in Fig. 2 herein, was evacuated to a pressure of $1.333 \cdot 10^{-3}$ mbar ($10^{-3}$ Torr or mm Hg). The heating elements 28 were activated to heat the substrate 26 to a temperature of 150°C.

Using the apparatus and procedure just described, a layer of silicon nitride was deposited on a silicon substrate at a rate in excess of 0.4000 μm/h (4,000 Å/h). By comparison, the deposition rate of the prior art process discussed herein is typically 0.0050 µm/min (50 Å/min) initially and decreases rapidly due to the accumulation of ultraviolet radiation-absorbing deposits on the quartz window. Deposition of the silicon nitride in such prior art processes typically ceases after approximately 45 minutes, providing a total maximum film thickness of approx. 0.1000 to 0.1400 µm (1000 to 1400 Å). Thus, a significant increase in the deposition rate can be achieved by using the process of the present invention. In addition, the process of the present invention is particularly useful for avoiding the prior art leveling-out problem during a continuous photochemical vapor deposition process, in which the amount of material deposited decreases significantly with extended processing time periods. The deposition rate of the present invention can be maintained essentially constant for a period in excess of 3 hours. In actual practice, it has been found that one perfluorinated polyether polymer-coated quartz window may be used for four successive deposition processes in accordance with the process of the present invention. After such time, the polymer coating degrades and must be removed and a new perfluorinated polyether polymer coating formed on the quartz window.

While the present invention has been particularly described with respect to the preferred embodiments thereof, it will be recognized by those skilled in the art that certain other modifications in form and detail may be made.

The perfluorinated polyether may be deposited as a film onto the quartz window in accordance with known processes for forming such films and is not limited to the particular process described herein.

Finally, it is also intended to include a method for depositing a layer of silicon nitride material on a substrate or target in a predetermined pattern, such as lines or stripes, rather than as a continuous film. Such deposition of a patterned layer would require that the initiating radiation for the photochemical reaction be caused to strike only selected portions of the substrate or target onto which it is desired to form a deposit. The radiation could be focused on selected portions of the target or the radiation could be passed through a mask, such as a stainless steel mask placed over the target within the reaction chamber, to cause the radiation to strike selected portions of the target. Optionally, a layer of the perfluoropolyether material which is used to protect the internal face of the quartz window may also be formed on the surface of the substrate in a predetermined pattern to serve as a mask during the photochemical vapor deposition of the selected material on the substrate in a predetermined pattern. As yet another option, laser radiation of a wavelength of 0.2537 µm could provide the required limited and directed radiation for depositing such a patterned layer.

## Claims

1. Method for the photochemical vapor deposition of a layer of radiation-opaque silicon nitride material on the surface of a substrate by the radiation-induced chemical reaction of silane and ammonia as vapor phase reactants in a reaction chamber including a radiation-transparent quartz window on one wall of said chamber, comprising passing radiation of a wavelength of 0.2537 µm through said window and into said chamber containing said vapor phase reactants and mercury vapor to induce said photochemical vapor deposition of said material on the surface of the substrate positioned within the chamber being under vacuum, characterized by the fact that a film consisting of a perfluorinated polyether is provided on the internal face of said window prior to carrying out the vapor deposition process.

2. Method according to claim 1, characterized in that the perfluorinated polyether is Fomblin Y25.

3. Method according to claim 1 or 2, characterized in that said radiation is passed through both said window and said film to strike predetermined portions of a substrate for said photochemical vapor deposition, positioned within said chamber, to thereby form a desired patterned layer of said reaction products on said substrate.

## Patentansprüche

1. Verfahren zur photochemischen Dampfabscheidung einer Schicht aus strahlungsundurchlässigem Siliziumnitrid-Material auf der Oberfläche eines Substrats durch die strahlungsinduzierte chemische Reaktion von Silan und Ammoniak als Gasphasenreaktanden in einer Reaktionskammer, die ein strahlungsdurchlässiges Quarzfenster an einer Wand der Kammer enthält, umfassend das Hindurchgehen von Strahlung einer Wellenlänge von 0,2537 Mikrometer durch das Fenster und in die Kammer, die die Gasphasenreaktanden und Quecksilbergas zur Induzierung der photochemischen Dampfabscheidung des Materials auf der Oberfläche des Substrats, das innerhalb der unter Vakuum befindlichen Kammer angeordnet ist, enthält, dadurch gekennzeichnet, daß ein Film, der aus einem perfluorierten Polyäther besteht, an der Innenfläche des Fensters vor Ausführung des Dampfabscheidungsverfahrens vorgesehen ist.

2. Verfahren nach Anspruch 1, dadurch gekennzeichnet, daß der perflourierte Polyäther Fomblin Y25 ist.

3. Verfahren nach Anspruch 1 oder 2, dadurch gekennzeichnet, daß die Strahlung sowohl durch das Fenster als auch durch den Film hindurchgeht, um auf vorbestimmte Bereiche eines Substrats für die photochemische Dampfabscheidung zu treffen, das innerhalb der Kammer angebracht ist, um dadurch eine Schicht mit einem erwünschten Muster der Reaktionsprodukte auf dem Substrat zu bilden.

## Revendications

1. Procédé de déposition photochimique en phase vapeur d'une couche de matière à base de nitrure de silicium opaque aux rayonnements sur la surface d'un substrat par la réaction chimique, induite par des rayonnements, de silane et d'ammoniac comme corps réactionnels en phase vapeur dans une chambre de réaction comprenant une fenêtre en quartz transparente aux rayonnements sur une paroi de ladite chambre, consistant à faire arriver des rayonnements d'une longueur d'onde de 0,2537 µm à travers ladite fenêtre dans ladite chambre contenant lesdits corps réactionnels en phase vapeur et de la vapeur de mercure pour induire la déposition photochimique en phase vapeur de ladite matière sur la surface du substrat mis en place à l'intérieur de la chambre qui se trouve sous vide,

caractérisé par le fait qu'un film consistant en un polyéther perfluoré est prévu sur la face interne de ladite fenêtre avant la mise en oeuvre du processus de déposition en phase vapeur.

2. Procédé suivant la revendication 1, caractérisé en ce que le polyéther perfluoré est le produit Fomblin Y25.

3. Procédé suivant la revendication 1 ou 2, caractérisé en ce que les rayonnements sont amenés à traverser la fenêtre et le film pour frapper des parties prédéterminées d'un substrat pour ladite déposition photochimique en phase vapeur, mis en place dans ladite chambre, de manière à former ainsi une couche desdits produits de réaction selon une configuration désirée sur ledit substrat.

Fig. 1.

Fig. 2.